Europäisches Patentamt

European Patent Office

Office européen des brevets

(19)

(11) Publication number: **0 103 138**
**B1**

(12) # EUROPEAN PATENT SPECIFICATION

(45) Date of publication of patent specification: **19.11.87**

(51) Int. Cl.⁴: **H 01 L 29/91**

(21) Application number: **83107656.7**

(22) Date of filing: **03.08.83**

(54) Semiconductor rectifier diode.

(30) Priority: **11.08.82 JP 138584/82**

(43) Date of publication of application:
**21.03.84 Bulletin 84/12**

(45) Publication of the grant of the patent:
**19.11.87 Bulletin 87/47**

(84) Designated Contracting States:
**DE FR**

(56) References cited:
**EP-A-0 077 004**
**EP-A-0 090 722**
**DE-A-3 231 676**
**FR-A-2 288 390**
**FR-A-2 456 389**

(73) Proprietor: **HITACHI, LTD.**
**6, Kanda Surugadai 4-chome Chiyoda-ku**
**Tokyo 100 (JP)**

(72) Inventor: **Naito, Masayoshi**
**3449-5, Higashiishikawa**
**Katsuta-shi (JP)**
Inventor: **Shimizu, Yoshiteru**
**3600-119, Nakane**
**Katsuta-shi (JP)**
Inventor: **Terasawa, Yoshio**
**622-19, Ichige**
**Katsuta-shi (JP)**
Inventor: **Murakami, Susumu**
**3271-110, Nakane**
**Katsuta-shi (JP)**

(74) Representative: **Patentanwälte Beetz sen. -**
**Beetz jun. Timpe - Siegfried - Schmitt-Fumian**
**Steinsdorfstrasse 10**
**D-8000 München 22 (DE)**

# 0 103 138

**Description**

The present invention relates to a semiconductor rectifier diode.

In recent years, IC's and LSI's have been rapidly introduced into a computer and associated various terminal units or various system apparatuses. A low voltage stabilized DC power supply is demanded to feed such an apparatus. Among various methods for obtaining a low voltage stabilized DC power supply from the commercial AC power source, the switching regulator system is excellent in its small size and high efficiency.

Properties demanded for a rectifier diode to be used in the above described power supply are low loss, high stability and quick response. Diodes heretofore known did not fully satisfy these requirements. For example, a Schottky barrier diode described in the Japanese Patent Application JP—A—80 107272 has a large reverse leak current and a rather large thermal instability.

A p-i-n junction diode does not fully satisfy the low loss requirement. It has been proposed to make the p-type layer or n-type layer of a p-i-n diode extremely thin to improve the low-loss property as described in IEEE Transactions on Electron Devices, Vol. ED-23, No. 8, August 1976, p.p. 945 to 949. Similarly to the Schottky barrier diode, however, this approach does not always facilitate production of the p-i-n diode and has often brought about a difficulty in obtaining high fabrication yield due to variation in blocking voltage.

A semiconductor rectifier diode is already described in EP—A—0 077 004 falling under Article 54(3) EPC from which the subject matter according to the present claim 1 differs by the additional feature that the impurity concentration in the base layer is increased with increasing distance from the p-n junction.

From FR—A—2 456 389, a similar semiconductor diode is known, the first emitter structure of which consists of two portions differing in thickness and impurity concentration. In this prior art there is, however, no specification of the width of the first emitter portion with regard to pinch-off. Furthermore, no increase of the impurity concentration in the base layer is provided and a completely different problem is dealt with.

A further semiconductor diode comprising a two-part base layer of increasing impurity concentration in order to reduce the reverse recovery voltage is described in EP—A—0 090 722 which also falls within the terms of Article 54(3) EPC. This known diode, however, does not show the first emitter structure according to the present subject matter.

The object of the present invention is to provide a semiconductor rectifier diode which meets low loss, high stability and quick response requirements and can easily be produced, and which has further soft reverse recovery characteristic.

A semiconductor rectifier diode which conforms to the above object comprises according to claim 1 a semiconductor substrate having a pair of main surfaces thereon and a pair of main electrodes making ohmic contact to said main surfaces, said semiconductor substrate including a first emitter layer of a first conductivity type which is adjacent to one of said main surfaces and in contact with one of said main electrodes, a base layer of a second conductivity type being adjacent to said first emitter layer and forming a p-n junction between said first emitter layer and said base layer, and a second emitter layer of the second conductivity type being adjacent to said base layer and to the other one of said main surfaces and being in contact with the other one of said main electrodes; and

said first emitter layer including a first portion and second portions which together surround said first portion on said one main surface, extend further than said first portion in a direction perpendicular to said one main surface, and have a higher impurity concentration as compared with said first portion,

a width of said first portion of said first emitter layer, when viewed in a direction parallel to said main surfaces, having a sufficient value so that said base layer is pinched off at a portion thereof lying under said first portion and between said second portions of said first emitter layer by a depletion layer produced when the p-n junction is reverse-biased with the rated voltage of said diode, and the impurity concentration in said base layer being increased with increase in the distance from said p-n junction.

In a first advantageous embodiment the base layer comprises a first layer portion which is adjacent to said second emitter layer and a second layer portion which is adjacent to said p-n junction and has a lower impurity concentration as compared with said first layer portion.

In a further advantageous embodiment the semiconductor rectifier diode is featured in that the impurity concentration in said first layer portion of said base layer is lower than the carrier concentration in the forward conductive state of the device and is sufficient to prevent the depletion layer from widening beyond said first layer portion under the reverse blocking state.

In a further advantageous embodiment the semiconductor rectifier diode is featured in that said base layer is composed of a single region in which the impurity concentration is continuously increased with increase in the distance from said p-n junction.

In a further advantageous embodiment the semiconductor rectifier diode is featured in that the impurity concentration in a portion of said base layer which is located near said second emitter layer is lower than the carrier concentration in the forward conductive state of the device and is sufficient to prevent said depletion layer from widening beyond said portion under the reverse blocking state.

In a further advantageous embodiment the semiconductor rectifier diode is featured in that said first portion of said first emitter layer is composed of a plurality of regions arranged in a stripe form.

The present invention will be apparent from the following detailed description taken in conjunction with the accompanying drawings, in which:

2

Fig. 1 is a schematic oblique view of an embodiment of a semiconductor rectifier diode according to the present invention;

Fig. 2 is a plan view of a semiconductor substrate of the device illustrated in Fig. 1;

Fig. 3 is an enlarged view of the principal part of the device illustrated in Fig. 1;

Fig. 4 shows the distribution of the impurity concentration within the device illustrated in Fig. 1;

Fig. 5 shows characteristic curves illustrating the relationship between the width of the first portion of the p-type emitter layer and the forward voltage drop in the device illustrated in Fig. 1;

Fig. 6 shows characteristic curves illustrating the relationship between the width of the first portion of the p-type emitter layer and the blocking voltage in the device illustrated in Fig. 1;

Fig. 7 shows characteristic curves illustrating the relationship between the surface impurity concentration of the first portion of the p-type emitter layer and the forward voltage drop in the device illustrated in Fig. 1;

Fig. 8 shows a characteristic curve illustrating the relationship between the surface impurity concentration of the first portion of the p-type emitter layer and the reverse recovery time in the device illustrated in Fig. 1;

Fig. 9 shows characteristic curves illustrating the relationship between the surface impurity concentration of the first portion of the p-type emitter layer and the reduction rate of the reverse recovery current in the device illustrated in Fig. 1;

Fig. 10 is a schematic sectional view of another embodiment of a semiconductor rectifier diode according to the present invention; and

Figs. 11a and 11b respectively illustrate the structure and the impurity concentration profile of still another embodiment of a semiconductor rectifier diode according to the present invention.

Hereafter, embodiments of the present invention will be described in detail by referring to the drawings.

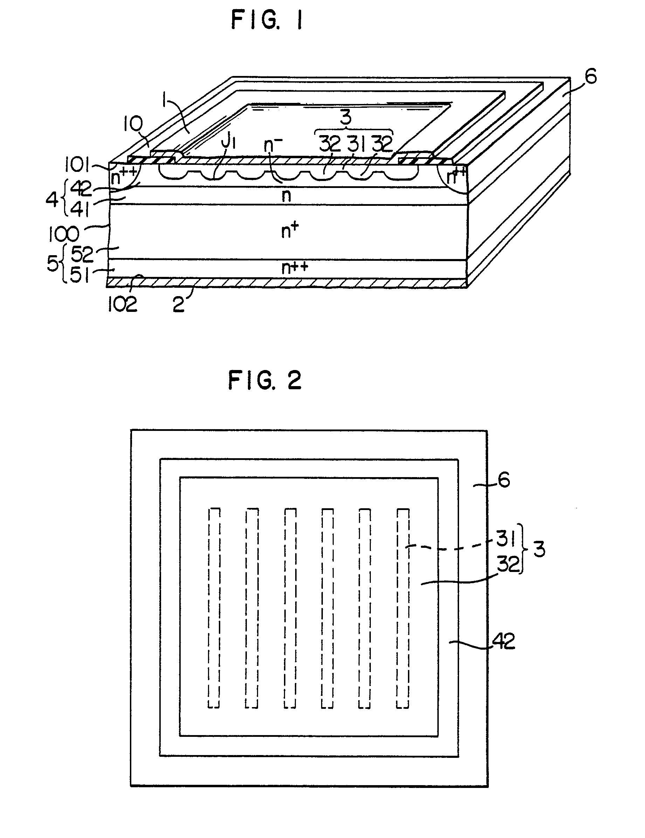

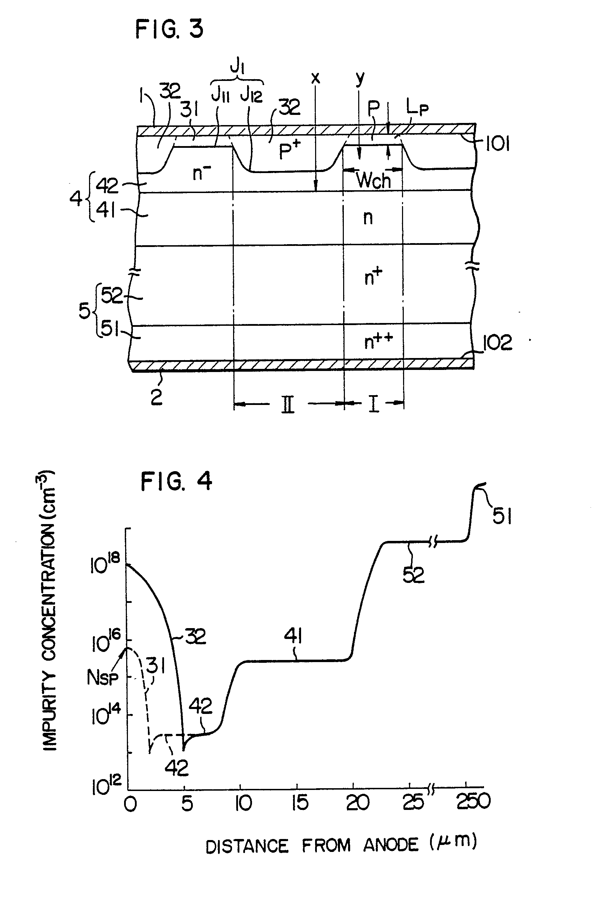

In Fig. 1, Fig. 2 and Fig. 3, a semiconductor substrate 100 has a pair of main surfaces 101 and 102. Between the pair of main surfaces 101 and 102, there are an n-type emitter layer 5 composed of an $n^{++}$-type layer portion 51 which is adjacent to the main surface 102 and an $n^{+}$-type layer portion 52 which is adjacent to the layer portion 51 and is lower than that layer portion 51 in concentration, an n-type base layer 4 which is adjacent to the layer 5 and is lower than the layer 5 in concentration, and a p-type emitter layer 3 which is adjacent to the main surface 101 and is adjacent to the layer 4 to form a p-n junction $J_1$. Thus, the semiconductor substrate 100 has a structure composed of consecutive layers. The n-type base layer 4 is composed of a first layer portion 41 which is adjacent to the layer 5 and a second layer portion 42 which is placed between the layer portion 41 and the layer 3 and is lower than the portion 41 in concentration. The p-type emitter layer 3 is composed of a first portion 31 which is thin in thickness and low in concentration and second portions 32 which have a higher concentration than the first portion 31 and are formed more deeply than the first portion 31. The first portion 31 and the second portions 32 are formed in stripe-shape and are alternately arranged so that they face one another lengthwise. On the main surface 101, the first portion 31 is surrounded by the second portions 32 as illustrated in Fig. 2. Fig. 1 and Fig. 3 are sectional view viewed from the direction perpendicular to the length of the stripes. Thus, the p-n junction $J_1$ is composed of a first portion $J_{11}$ formed between the portions 31 and 42 and a second portion $J_{12}$ formed between the portions 32 and 42. In Fig. 3, symbol I denotes a first laminated structure, each layer of which overlaps with the junction $J_{11}$ when projected onto the main surface 102. Symbol II denotes a second laminated structure, each layer of which overlaps with the junction $J_{12}$ when projected onto the main surface 102.

On a portion of the main surface 101 whereon the p-n junction is exposed, an $SiO_2$ film 10 is formed. On the exposed portion of the p-type emitter layer 3, an anode electrode 1 which is in ohmic contact with the p-type emitter layer 3 is formed. On the main surface 102, a cathode electrode 2 which is in ohmic contact with the n-type emitter layer is formed. On the $SiO_2$ film, the anode electrode 1 is extended outward from the end of the exposed portion of the p-n junction $J_1$ to serve as a field plate.

A solid line in Fig. 4 illustrates the distribution of impurity concentrations within the second laminated structure II of the semiconductor substrate taken in a direction which is denoted by x in Fig. 3. In Fig. 4, the distribution of impurity concentrations within the first laminated structure I taken in a direction which is denoted by y in Fig. 3 is also illustrated. For the first laminated structure I, however, only a portion of the distribution which differs from that of the second laminated structure II is illustrated in Fig. 4 by a broken line.

A diode of this embodiment may be fabricated by using a well known semiconductor fabrication technique. An example of the fabrication is described in the following.

At first, on one face of an $n^{-}$-type monocrystalline silicon wafer, an n-type layer and an $n^{-}$-type layer are successively formed by epitaxial growth technique to yield a silicon substrate. Phosphor is diffused selectively from one main surface and entirely from the other main surface. Thus, an $n^{++}$-type layer 6 which is exposed to a periphery of one main surface 101 at the chip end and an $n^{++}$-type layer 51 which is exposed to the other main surface 102 are formed. Subsequently, boron is selectively diffused from the main surface 101 by using an oxide film as a mask, the second portions 32 being formed. From the main surface 101, boron is ion-implanted and subjected to heat treatment to form the first portion 31. Onto predetermined portions of main surfaces 101 and 102 of the silicon substrate, laminated films made of AlSi, Cr-Ni-Ag or the

0 103 138

like are evaporated to form the anode electrode 1 and the cathode electrode 2. The $SiO_2$ film 10 is deposited during the above described diffusion process or by the CVD method or the like.

The function and effect of the above described diode will now be described.

Under a so-called forward bias state wherein a positive voltage is applied to the anode electrode 1 with respect to the cathode electrode 2, the impurity concentration in the first portion 31 in the p-type emitter layer 3 is lower than that in the second portion 32 thereof. As a result, the diffusion potential of the first portion $J_{11}$ within the p-n junction $J_1$ becomes lower than that of the second portion $J_{12}$. Accordingly, the main current flows mainly through the first laminated structure I wherein the first portion 31 serves as one of the emitters. When the first laminated structure I thus becomes the main current path, minority carriers contribute to operation between the first portion 31 and the anode electrode 1 because the diffusion potential is low and the first portion 31 is thin. And the barrier between the first portion 31 and the anode electrode is not an obstacle to the carrier movement. As a result, the forward voltage may be made smaller than that in the case where the second laminated structure II is the main current path. In addition, the total amount of impurities included in the first portion 31 of the p-type emitter layer 3 is less than that included in the second portions 32 since the first portion 31 of the p-type emitter layer 3 is thinner than the second portions 32 thereof and the former has a lower impurity concentration as compared with the latter. Under the forward bias state, therefore, the amount of carriers injected from the p-type emitter layer 3 into the n-type base layer 4 is small. Thus, it becomes possible to reduce the reverse recovery time required for transition from the forward bias state to the reverse bias state.

Under a so-called reverse bias state wherein a negative voltage is applied to the anode electrode 1 with respect to the cathode electrode 2, a depletion layer formed near the p-n junction $J_1$ extends mainly in the n-type base layer 4 in the vicinity of the second portion $J_{12}$ due to the difference between the impurity concentration in the second portion 32 within the p-type emitter layer 3 and that in the n-type base layer 4. Therefore, the second layer portion 42 of the n-type base layer 4 located between the second portions 32 and under the first portion 31 is pinched off by the depletion layer extending from the second portion $J_{12}$ of the p-n junction. Accordingly, the strength of the electric field in the first portion $J_{11}$ of the p-n junction is weakened. Since the first portion 31 is thin and has a low impurity concentration, the first portion $J_{11}$ of the p-n junction tends to be easily punched through to the surface by the depletion layer extending in the p-type emitter layer side and therefore has a low blocking voltage. Owing to the depletion layer caused by the existence of the second portions 32, however, the voltage is blocked and the first portions $J_{11}$ is prevented from being punched through. As a result, it becomes possible to obtain a blocking voltage which is equivalent to that obtained when the p-type emitter layer is composed of only the second portions 32.

At this time, the depletion layer extending from the second portion $J_{12}$ of the p-n junction $J_1$ toward the other main surface 102 is prevented from further widening beyond the vicinity of the boundary between the first layer portion 41 and the second layer portion 42 included in the n-type base layer 4 or beyond the first layer portion 41. When the diode is switched from the foward conduction state to the reverse blocking state, the first layer portion 41 which is filled with injected carriers remains as a neutral region within the n-type base layer 4 even after the depletion layer base been formed. From the time when the reverse current reaches its peak value until the time when the carriers in the neutral region disappear, the reverse current flows while decreasing gradually, whereby the reverse recovery characteristic being softened. The "soft" reverse recovery characteristic means that the reduction rate $di_R/dt$ of the reverse current $i_R$ after it has reached its peak value is rather small. Should the reverse current decrease rapidly, a large voltage L $di_R/dt$ is induced by the inductance L included in the circuit comprising the diode, noises being incurred.

As described above, embodiments of the present invention illustrated in Figs. 1, 2 and 3 yield a semiconductor rectifier diode which excels a conventional junction diode in low loss, quick response and soft recovery properties and excels a Schottky barrier diode in stability and high breakdown voltage properties. The p-type emitter layer 3 is divided into the first portion 31 and the second portions 32, and design objectives which are incompatible with each other such as a lowered loss and a raised breakdown voltage are separately achieved by the first and second portions, respectively. Accordingly, the design of the p-type emitter becomes easy. In addition, the blocking voltage is not lowered even if a defect such as a pinhole exists in the first portion 31. Thus, the fabrication yield may also be improved.

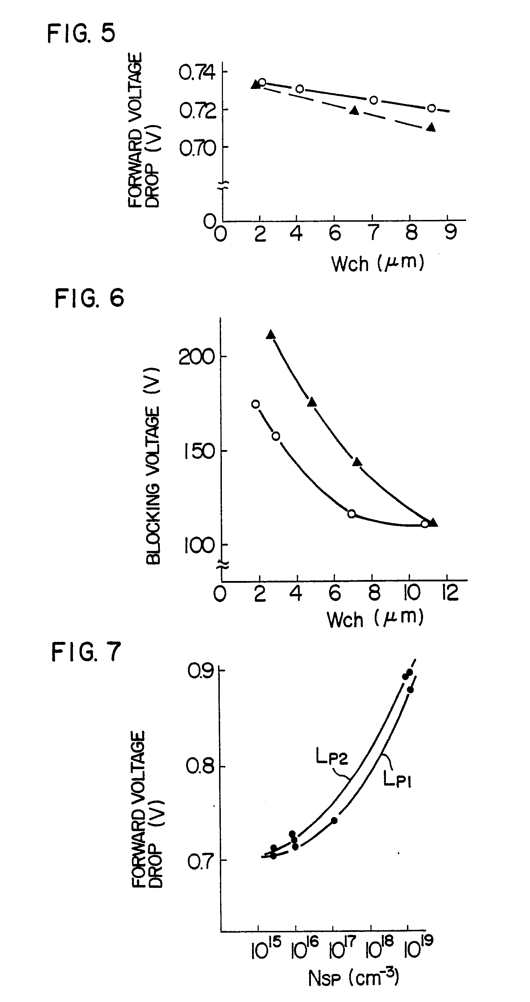

Fig. 5 shows the dependence of the forward voltage drop upon the width $W_{ch}$ of the first portion 31 within the diode illustrated in Figs. 1, 2 and 3. Fig. 6 shows the dependence of the blocking voltage upon the width $W_{ch}$. In these cases, the current density is approximately 60 $A/cm^2$, the thickness $L_p$ of the first portion 31 is approximately 2 μm, the thickness of the second portion 32 is approximately 5 μm, the thickness of the second layer portion 42 existing between the bottom portion of the first portion 31 and the first layer portion 41 is approximately 6 μm, the thickness of the first layer portion 41 is approximately 12 μm, the impurity concentration in the first layer portion 41 is approximately $3 \times 10^{15}$ $cm^{-3}$, and the surface impurity concentration in the first portion 31 taken on the main surface 101 is approximately $5 \times 10^{15}$ $cm^{-3}$. Symbols ▲ and ○ in Fig. 5 and Fig. 6 correspond to impurity concentrations of approximately $3 \times 10^{13}$ $cm^{-3}$ and approximately $1 \times 10^{14}$ $cm^{-3}$ in the second layer portion 42, respectively.

As seen from Fig. 5 and Fig. 6, reducing the width of the first portion 31 from 10 μm to 2 μm raises the blocking voltage by approximately 70 V only at a cost of increase in the forward voltage drop of approximately 0.02 V even when the surface impurity concentration in the first portion 31 is as low as approximately $5 \times 10^{15}$ $cm^{-3}$ and the thickness thereof is as thin as approximately 2 μm.

4

The effect of the surface impurity concentration NSP in the first portion 31 upon the characteristics of the diode in this embodiment will now be described.

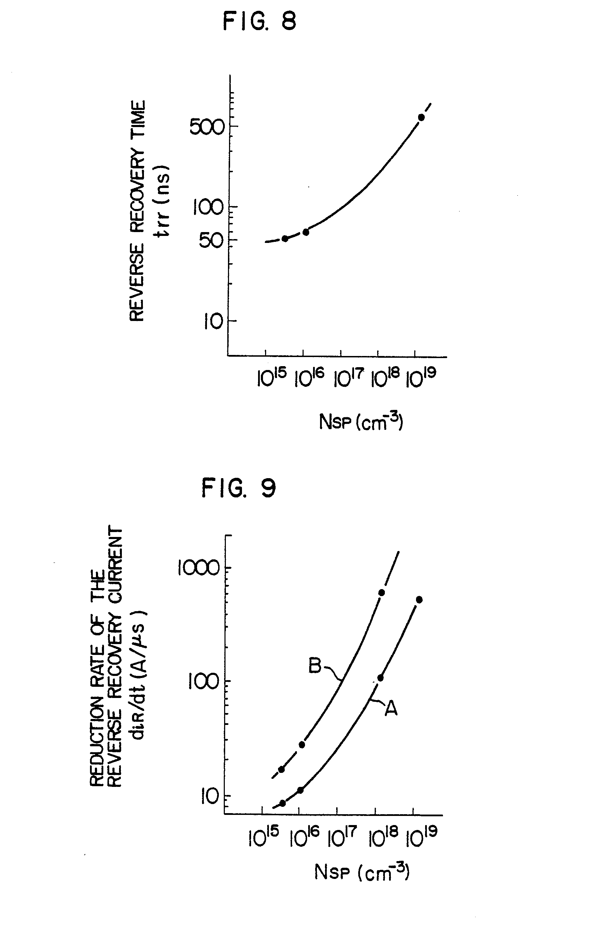

Fig. 7 and Fig. 8 respectively illustrate the forward voltage drop and reverse recovery time $t_{rr}$ when the thickness $L_p$ of the first portion 31 is chosen to be 1 µm (represented by $L_{p1}$) or 2 µm (represented by $L_{p2}$). The forward current density was conditioned to be approximately 60 A/cm². The reduction rate of the forward current during reverse recovery was conditioned to be approximately 30 A/µs.

Fig. 7 and Fig. 8 indicate that it becomes possible to lower the forward voltage and quicken the reverse recovery by decreasing the thickness of the first portion 31 to 1 to 2 µm and lowering the surface impurity concentation thereof. For example, when the thickness of the first portion 31 is 1 to 2 µm and the surface impurity concentration is below $1 \times 10^{16}$ cm$^{-3}$, the forward voltage drop is approximately 0.7 V and the reverse recovery time $t_{rr}$ is as low as 50 to 60 ns, a diode presenting a low loss and fast response being obtained. As the impurity concentration in the first portion 31 is lowered, reverse recovery is quickened because holes injected from the first portion 31 into the n-type base layer 4 under the forward bias state are decreased and whereby the amount of stored carriers is decreased. When the impurity concentration in the first portion 31 is lowered, the forward voltage is also lowered because the diffusion potential at the p-n junction $J_{11}$ is lowered.

Fig. 9 shows the reduction rate $di_R/dt$ of the reverse recovery current when the thickness $L_p$ of the first portion 31 is chosen to be approximately 2 µm. The impurity concentration in the second layer portion 42 is chosen to be approximately $3 \times 10^{13}$ cm$^{-3}$. In Fig. 9, curve A represents the reduction rate when the impurity concentration in the first layer portion 41 is approximately $3 \times 10^{15}$ cm$^{-3}$. In case of curve B, the impurity concentration in the first layer portion 41 is approximately $3 \times 10^{13}$ cm$^{-3}$ which is equal to that of the second layer portion 42. In this case, the impurity concentration in the n-type base layer 4 is chosen to be uniform in the layer-stacking direction. As the surface impurity concentration in the first portion 31 is decreased, the reduction rate $di_R/dt$ is lowered as illustrated in Fig. 9, resulting in a soft reverse recovery characteristic. If the impurity concentrations in the n-type base layer 4 are made to distribute over the layer so that a portion located near the n$^+$-type emitter layer 5 will have a higher concentration, the reduction rate $di_R/dt$ is further decreased as represented by the curve A instead of the curve B.

As illustrated in Fig. 6 as well, the lower the impurity concentration in a portion of the n-type base layer 4, which is located near the p-n junction $J_1$, is the higher the resulting blocking voltage is. Thus, it is possible to obtain the soft reverse recovery and high blocking voltage properties simultaneously by establishing the impurity concentration distribution in the n-type base 4 wherein a portion located near the p-n junction $J_1$ has a lower impurity concentration and another portion located far from the p-n junction $J_1$ has a higher concentration.

The effect of the present invention will now be described referring to a numerical example.

Table 1 shows measured values of forward voltage drop, blocking voltage, reverse recovery time and reduction rate of the reverse recovery current both for a conventional junction diode and a diode fabricated according to the present invention. The conventional junction diode used for the measurement is composed of p-type emitter layer having an impurity concentration of $1 \times 10^{19}$ cm$^{-3}$ and a thickness of 5 µm, an n-type base layer having an impurity concentration of $5 \times 10^{14}$ cm$^{-3}$ and a thickness of 7 µm, and an n-type emitter layer having an impurity concentration of $5 \times 10^{18}$ cm$^{-3}$ and a thickness of 300 µm. And the diode fabricated according to the present invention is composed of a p-type emitter layer which includes the first portion having an impurity concentration of $5 \times 10^{15}$ cm$^{-3}$, a thickness of 2 µm and a width of 4 µm and the second portion having an impurity concentration of $1 \times 10^{18}$ cm$^{-3}$ and a thickness of 5 µm, the n-type base layer which includes the first layer portion having an impurity concentration of $3 \times 10^{15}$ cm$^{-3}$ and thickness of 10 µm and the second layer portion having an impurity concentration of $3 \times 10^{13}$ cm$^{-3}$ and a thickness measured between the second portion of the p-type emitter layer and the first layer portion of 3 µm, and an n-type emitter layer which includes the n$^{++}$-type layer portion having an impurity concentration of $1 \times 10^{21}$ cm$^{-3}$ and a thickness of 5 µm and the n$^+$-type layer portion having an impurity concentration of $5 \times 10^{18}$ cm$^{-3}$ and a thickness of 295 µm.

## 0 103 138

TABLE 1

|  | Conventional diode | Diode fabricated according to the present invention |
|---|---|---|
| Forward voltage | 0.95 V | 0.73 V |
| Blocking voltage | 150 V | 180 V |
| Reverse recovery time | 500 nsec | 60 nsec |
| Reduction rate of reverse recovery current | 300 A/μsec | 10 A/μsec |

As evident from Table 1, the diode fabricated according to the present invention excels the conventional junction diode in all properties of forward voltage, blocking voltage, reverse recovery time and reduction rate of reverse recovery current.

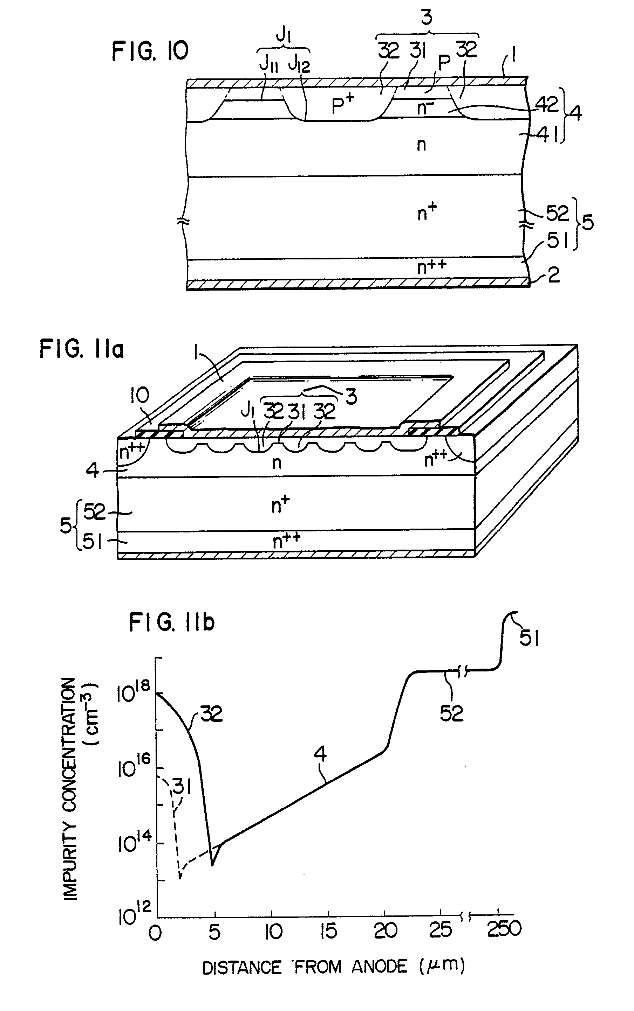

Fig. 10 shows another embodiment of a semiconductor rectifier diode according to the present invention. The diode illustrated in Fig. 10 differs from the embodiment illustrated in Fig. 1 to Fig. 3 in the fact that the second portions 32 of the p-type emitter layer 3 is in contact with the first layer portion 41 of the n-type base layer 4 and the second layer portion 42 is not provided between each of the second portions 32 and the first layer portion 41. Although the blocking voltage of the diode thus constructed is slightly lowered as compared with the diode illustrated in Fig. 1 to Fig. 3, other properties are slightly improved.

Figs. 11a and 11b show still another embodiment of a semiconductor rectifier diode according to the present invention. The semiconductor illustrated in Figs. 11a and 11b differs from the embodiment illustrated in Fig. 1 to Fig. 3 in the fact that the n-type base layer 4 is composed of a single region wherein the impurity concentration therein is continuously increased with the increase in the distance from the p-n junction $J_1$. The diode thus constructed has characteristics which lie between those of the embodiment illustrated in Fig. 1 to Fig. 3 and those of the embodiment illustrated in Fig. 10.

Typical embodiments of the present invention have heretofore been described. However, the present invention is not restricted to those embodiments and various modifications may be applied to them. For example, the conductivity types of illustrated devices may be inverted. In addition, the first portion of the p-type emitter may also be formed in a shape other than the stripe, such as a circle, square or curve.

**Claims**

1. A semiconductor rectifier diode comprising a semiconductor substrate (100) having a pair of main surfaces (101, 102) thereon and a pair of main electrodes (1, 2) making ohmic contact to said main surfaces, said semiconductor substrate including a first emitter layer (3) of a first conductivity type which is adjacent to one (101) of said main surfaces and in contact with one (1) of said main electrodes, a base layer (4) of a second conductivity type being adjacent to said first emitter layer and forming a p-n junction ($J_1$) between said first emitter layer and said base layer, and a second emitter layer (5) of the second conductivity type being adjacent to said base layer and to the other one (102) of said main surfaces and being in contact with the other one (2) of said main electrodes; and said first emitter layer (3) including a first portion (31) and second portions (32) which together surround said first portion on said one main surface (101), extend further than said first portion (31) in a direction perpendicular to said one main surface (101), and have a higher impurity concentration as compared with said first portion (31),

a width ($W_{ch}$) of said first portion of said first emitter layer (3), when viewed in a direction parallel to said main surfaces (101, 102), having a sufficient value so that said base layer (4) is pinched off at a portion thereof lying under said first portion (31) and between said second portions (32) of said first emitter layer (3) by a depletion layer produced when the p-n junction ($J_1$) is reverse-biased with the rated voltage of said diode, and the impurity concentration in said base layer (4) being increased with increase in the distance from said p-n junction ($J_1$).

2. A semiconductor rectifier diode according to claim 1, wherein said base layer (4) comprises a first layer portion (41) which is adjacent to said second emitter layer (5) and a second layer portion (42) which is adjacent to said p-n junction ($J_1$) and has a lower impurity concentration as compared with said first layer portion.

3. A semiconductor rectifier diode according to claim 2, wherein the impurity concentration in said first layer portion (41) of said base layer (4) is lower than the carrier concentration in the forward conductive state of the device and is sufficient to prevent the depletion layer from widening beyond said first layer portion (41) under the reverse blocking state.

6

4. A semiconductor rectifier diode according to claim 1, wherein said base layer (4) is composed of a single region in which the impurity concentration is continuously increased with increase in the distance from said p-n junction ($J_1$).

5. A semiconductor rectifier diode according to claim 4, wherein the impurity concentration in a portion of said base layer (4) which is located near said second emitter layer (5) is lower than the carrier concentration in the forward conductive state of the device and is sufficient to prevent said depletion layer from widening beyond said portion under the reverse blocking state.

6. A semiconductor rectifier diode according to claim 2 or claim 4, wherein said first portion (31) of said first emitter layer (3) is composed of a plurality of regions arranged in a stripe form.

**Patentansprüche**

1. Halbleitergleichrichterdiode mit einem Halbleitersubstrat (100) mit einem Paar Hauptflächen (101, 102) und einem Paar Hauptelektroden (1, 2) in Ohmschem Kontakt mit den Hauptflächen,

wobei das Halbleitersubstrat eine erste Emitterschicht (3) einer ersten Leitfähigkeit, die zu einer (101) der Hauptflächen benachbart und mit einer (1) der Hauptelektroden in Kontakt ist, eine Grundschicht (4) einer zweiten Leitfähigkeit, die zu der ersten Emitterschicht benachbart ist und zwischen der ersten Emitterschicht und der Grundschicht einen p-n-Übergang ($J_1$) bildet, und eine zweite Emitterschicht (5) der zweiten Leitfähigkeit aufweist, die zur Grundschicht und zu der anderen (102) der Hauptflächen benachbart und mit der anderen (2) der hauptelektroden in Kontakt ist,

die erste Emitterschicht (3) einen ersten Bereich (31) und zweite Bereiche (32) umfaßt, die zusammen den ersten Bereich auf der einen Hauptfläche (101) umgeben, in senkrechter Richtung zu der einen Hauptfläche (101) weiter reichen als der erste Bereich (31) und eine höhere Konzentration an Verunreinigungen als der erste Bereich (31) haben,

der erste Bereich der ersten Emitterschicht (3) eine solche Breite ($W_{ch}$) in paralleler Richtung zu den Hauptflächen (101, 102) hat, daß die Grundschicht (4) in dem Bereich, der unter dem ersten Bereich (31) und zwischen den zweiten Bereichen (32) der ersten Emitterschicht (3) liegt, durch eine Verarmungszone verdrängt wird, die dann entsteht, wenn der p-n-Übergang ($J_1$) mit der Betriebsspannung der Diode umgekehrt vorbelastet wird, und

die Konzentration an Verunreinigungen in dieser Grundschicht (4) mit zunehmendem Abstand vom p-n-Übergang ($J_1$) steigt.

2. Halbleitergleichrichterdiode nach Anspruch 1, in der die Grundschicht (4) einen ersten Bereich (41), der zu der zweiten Emitterschicht (5) benachbart ist, und einen zweiten, dem p-n-Übergang ($J_1$) benachbarten Schichtbereich (42) umfaßt und eine niedrigere Konzentration an Verunreinigungen als der erste Schichtbereich aufweist.

3. Halbleitergleichrichterdiode nach Anspruch 2, in der die Konzentration an Verunreinigungen in dem ersten Schichtbereich (41) der Grundschicht (4) niedriger als die Trägerkonzentration im Durchlaßzustand der Vorrichtung ist und ausreicht, um zu verhindern, daß die Verarmungszone sich über den ersten Schichtbereich (41) im Rückwärtssperrzustand ausweitet.

4. Halbleitergleichrichterdiode nach Anspruch 1 in der die Grundschicht (4) aus einem einzigen Bereich besteht, in dem die Konzentration an Verunreinigungen ständig mit steigendem Abstand vom p-n-Übergang ($J_1$) zunimmt.

5. Halbleitergleichrichterdiode nach Anspruch 4, in der die Konzentration an Verunreinigungen in einem Bereich der Grundschicht (4), der sich nahe der zweiten Emitterschicht (5) befindet, niedriger als die Trägerkonzentration im Durchlaßzustand der Vorrichtung ist und ausreicht, um zu verhindern, daß die Verarumungszone sich über diesen Bereich im Rückwärtssperrzustand ausweitet.

6. Halbleitergleichrichterdiode nach Anspruch 2 oder 4, in der der erste Bereich (31) der ersten Emitterschicht (3) aus einer Vielzahl von in Streifenform angeordneten Bereichen besteht.

**Revendications**

1. Diode redresseuse semiconductrice comportant un substrat semiconducteur (100) possédant un couple de surfaces principales (101, 102) et un couple d'électrodes principales (1, 2) établissant un contact ohmique avec lesdites surfaces principales, ledit substrat semiconducteur comportant une première couche d'émetteur (3), qui possède un premier type de conductivité, est adjacente à une première (101) desdites surfaces principales et est en contact avec une première (1) desdites électrodes principales, une base (4), qui possède un second type de conductivité est adjacente à ladite première couche d'émetteur et forme une jonction p-n ($J_1$) entre ladite première couche d'émetteur et ladite couche de base, et une seconde couche d'émetteur (5), qui possède le second type de conductivité, est adjacente à ladite couche de base et à la seconde (102) desdites surfaces principales et est en contact avec la seconde (2) desdites électrodes principales; et

ladite première couche d'émetteur (3) comportant une première partie (31) et des secondes parties (32), qui entourent ensemble ladie première partie située sur ladite première surface principale (101), s'étendent au-delà de ladite première partie (31) dans une direction perpendiculaire à ladite première surface principale (101), et possèdent une concentration en impuretés, plus importante que celle de ladite première partie (31),

une largeur (W$_{ch}$) de ladite première partie de ladite première couche d'émetteur (3), lorsqu'on regarde dans une direction parallèle auxdites surfaces principales (101, 102), possédant une valeur suffisante telle que ladite couche de base (4) est rétrécie au niveau de sa partie située au-dessous de ladite première partie (32) et entre lesdites secondes parties (32) de ladite première couche d'émetteur (3), par une couche d'appauvrissement produite lorsque la jonction p-n (J$_1$) est polarisée en inverse par la tension nominale de ladite diode, et la concentration en impuretés dans ladite couche de base (4) augmentant au fur et à mesure que la distance à partir de ladite jonction p-n (J$_1$) augmente.

2. Diode redresseuse semiconductrice selon la revendication 1, dans laquelle ladite couche de base (4) comporte une première partie (41) qui est adjacente à ladite seconde couche d'émetteur (5), et une seconde partie (42) qui est adjacente à ladite jonction p-n (J$_1$) et possède une concentration en impuretés inférieure à celle de ladite première partie de la couche.

3. Diode redresseuse semiconductrice selon la revendication 2, dans laquelle la concentration en impuretés dans ladite première partie (41) de ladite couche de base (4) est inférieure à la concentration des porteurs lorsque le dispositif se trouve dans l'état conducteur dans le sens passant, et est suffisante pour empêcher un élargissement de la couche d'appauvrissement au-delà de ladite première partie (41) de la couche, dans l'état de blocage inverse.

4. Diode redresseuse semiconductrice selon la revendication 1, dans laquelle ladite couche de base (4) est constituée par une seule région, dans laquelle la concentration en impuretés argumente avec l'accroissement de la distance de la jonction p-n.

5. Diode redresseuse semiconductrice selon la revendication 4, dans laquelle la concentration en impuretés dans une partie de ladite couche de base (4), qui est située à proximité de ladite seconde couche d'émetteur (5), est inférieure à la concentration des porteurs lorsque le dispositif est dans l'état conducteur dans le sens passant, et est suffisante pour empêcher un élargissement de ladite couche d'appauvrissement au-delà de ladite partie, dans l'état de blocage inverse.

6. Diode redresseuse semiconductrice selon la revendication 2 ou 4, dans laquelle ladite première partie (31) de ladite première couche d'émetteur (3) est constituée par une pluralité de régions disposées sous la forme de bandes.

# FIG. 1

# FIG. 2

## FIG. 3

## FIG. 4

IMPURITY CONCENTRATION (cm$^{-3}$)

DISTANCE FROM ANODE ($\mu$m)

FIG. 5

FIG. 6

FIG. 7

## FIG. 8

## FIG. 9

FIG. 10

FIG. IIa

FIG. IIb